# EUROPEAN PATENT APPLICATION

(11) **EP 2 762 865 A1**
(43) Date of publication of application: **06.08.2014**
(21) Application number: 13405017.8
(22) Date of filing: 31.01.2013
(51) Int. Cl.: G01N 27/12, G01N 27/18

(54) **Chemical sensor and method for manufacturing such a chemical sensor**

(71) Applicant: Sensirion Holding AG, 8712 Stäfa (CH)
(72) Inventor: Mayer, Felix, 8712 Stäfa (CH); Lechner, Moritz, 8713 Uerikon (CH); Kümin, Cyrill, 8640 Rapperswil (CH); Hummel, René, 6340 Baar (CH); Sunier, Robert, 8800 Thalwil (CH)
(74) Representative: Fischer, Britta Ruth

(57) **Abstract**

The invention relates to a chemical sensor (1) comprising a substrate layer (2) having a front surface (2.1) and a back surface (2.2) and a sensing layer (3) arranged on the front surface (2.1) of the substrate layer (2), the sensing layer (3) comprising a sensing element (4) and the substrate layer (2) being provided with a well (5) in the back surface (2.2) to a form a membrane (6) that incorporates the sensing element (4), wherein the substrate layer (2) is provided with contact pads (10) on the back surface (2.2) and with vias (11) extending from the front surface (2.1) to the back surface (2.2) for electrically connecting the sensing element (4) with the contact pads (10), wherein a handling layer (17) is provided on top of the sensing layer (3), the handling layer (17) surrounding the sensing element (4), and wherein the thickness (d1) of the handling layer (17) is larger than the thickness (d2) of the substrate layer (2). The invention furthermore relates to a method for manufacturing such a chemical sensor (1).

## Description

### Technical Field

The invention relates to a chemical sensor and a method for manufacturing such a chemical sensor according to the preambles of the independent claims. The chemical sensor may in particular be a gas sensor.

### Background Art

Chemical sensors as disclosed, for example, in GB 2 464 016 B comprise a semiconductor substrate with a front surface and a back surface. A sensing element is formed on the front surface that is provided with a gas-sensitive layer and a heater for heating the gas-sensitive layer to promote gas reaction with the gas-sensitive layer. The gas-sensitive layer is located between electrodes for providing an electrical output indicative of the gas reaction with the gas-sensitive layer. A well is formed in the back surface of the substrate layer to leave a membrane that incorporates the sensing element. Such chemical sensors can be employed for measuring a property of a fluid - and thereby an analyte that forms part of the fluid - that the chemical sensor is exposed to through an opening/a port in the housing of a portable electronic device such as for example a smart phone. Such a property may for example be the amount of carbon dioxide or ozone in the ambient air. A fluid may be a gas or a liquid.

To connect such a chemical sensor to an electric circuit board for further processing of the electrical output of the sensing element, with the sensing element exposable to a fluid to be analysed, typically bond wires are employed electrically connecting the electrodes of the sensing element to contact pads on the electric circuit board. The bond wires are usually enclosed by a pourable compound in form of respective glob-tops for protection. However, the glob-tops require space, space being rare especially in portable electronic devices such as smart phones. Furthermore, the provision of the glob-tops might impair functioning of the gas-sensitive layer due to the glob-tops typically being located close to the sensing element and the membrane, respectively.

### Disclosure of the Invention

It is an object of the invention to provide a chemical sensor by which the above-mentioned disadvantages can be avoided. It is a further object of the invention to provide a method for manufacturing such a chemical sensor.

In order to implement these and still further objects of the invention, which will become more readily apparent as the description proceeds, a chemical sensor is provided that comprises a substrate layer, a sensing layer and a handling layer. The substrate layer has a front surface and a back surface and the sensing layer is arranged on the front surface of the substrate layer. The substrate layer is provided with a well in the back surface to form a membrane that incorporates a sensing element of the sensing layer.

The substrate layer is further provided with contact pads on the back surface and with vias extending from the front surface to the back surface for electrically connecting the sensing element with the contacts pads. The contact pads may be electrically connected to an electric circuit board. The vias are in particular given by so-called through-silicon vias (confer http://en.wikipedia.org/wiki/Through-silicon_via), with the material of the substrate layer being silicon.

The handling layer is provided on top of the sensing layer, the handling layer surrounding the sensing element such that above the sensing element there is provided a cavity for fluid to reach the sensing element. The handling layer serves for protection of the sensing element. The thickness of the handling layer is larger than the thickness of the substrate layer. The handling layer preferably consists of wafer material, which is relatively hard. Preferentially, the handling layer is made of silicon or glass.

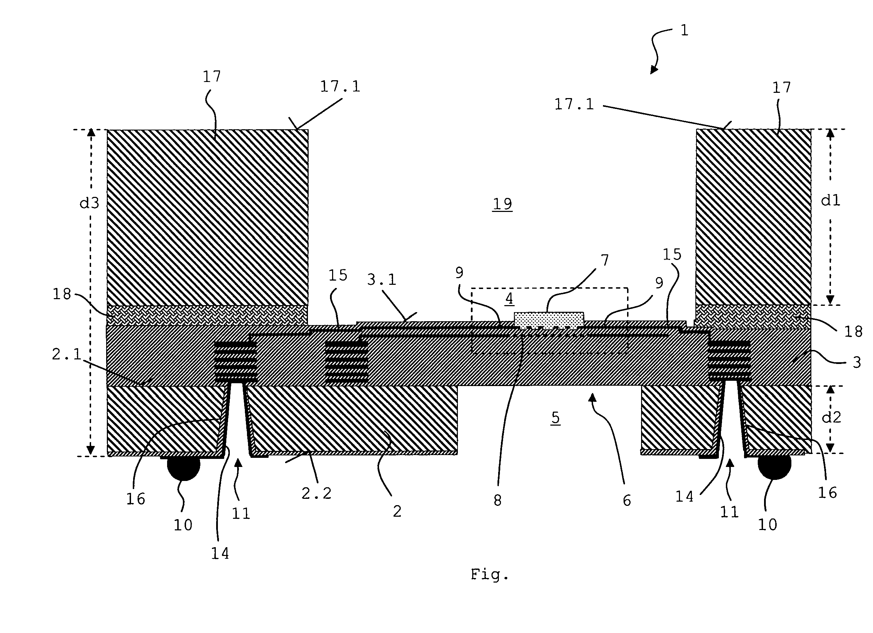

Expressions such as "on top", "front", "back", "bottom", "above", "below" or similar refer to a chemical sensor of the invention as depicted in Figure 1.

Through the use of vias instead of bond wires enclosed by glob-tops for electrically connecting the sensing element to an electric circuit board by way of the contact pads valuable space can be saved leading to a smaller chemical sensor in particular in the horizontal direction. Possible impairment of the sensing element and the membrane, respectively, caused by the provision of bond wires on top of the sensing layer, for example through the pouring of compound, can advantageously be avoided. Furthermore, without the glob-tops dead space above the sensing element is reduced leading to a shorter response time of the chemical sensor. The electrical connections given by the vias are also not exposed to corrosion as they are not exposed to the fluid that shall be analysed by the chemical sensor.

The handling layer allows for safe mechanical handling of the chemical sensor, for example when gripping the chemical sensor or holding/moving the chemical sensor by way of suction, while protecting the sensing element from external influences. The handling layer thus acts as protective cap and also as filter layer, filtering out possibly disturbing external influences from the sensing element. For this, the thickness of the handling layer is preferably at least 50 per cent of the thickness of the entire chemical sensor. By means of the vias shorter electrical connections can be realized than with bond wires. Hence, the substrate layer can be reduced in thickness such that it is less thick than the handling layer. For handling (for example for mounting on an electric circuit board) the thicker handling layer instead of the substrate layer can be used.

It is emphasized that the chemical sensor according to the invention, i.e. a chemical sensor in form of a TSV-package (also called chip-scale package) does not require more space/volume, in particular more surface area/ground area, than a conventional, unpackaged sensor die/chip thus forming the most space efficient way of packaging.

The invention furthermore relates to a method for manufacturing such a chemical sensor. In a first step a sensing layer that includes the sensing element is formed on a bulk substrate such as a first wafer, in particular a silicon wafer. Then a handling layer is formed on top of the sensing layer such that it surrounds the sensing element. The handling layer can be formed by employing a second wafer, which preferably also is a silicon wafer.

After the handling layer has been formed, the bulk substrate on top of which the sensing layer is arranged can be reduced in thickness to form a substrate layer with a thickness that is less than the thickness of the handling layer. The reduction in thickness can for example be achieved through grinding, etching or milling. The thickness of the bulk substrate is preferably reduced to such a thickness that the thickness of the handling layer is less than 50 per cent of the thickness of the entire chemical sensor. For further handling of the chemical sensor the handling layer is preferably used instead of the substrate layer.

After that, vias are formed in the substrate layer, the vias extending from the front surface of the substrate layer to the back surface. Then a well is formed in the back surface of the substrate layer to leave a membrane that incorporates the sensing element. The well may for example be formed by back etching.

For arranging the handling layer on top of the sensing layer an adhesive layer is preferably provided between the sensing layer and the handling layer, the adhesive layer surrounding the sensing element and connecting the handling layer with the top of the sensing layer.

Advantageously, the method of the invention can be employed to simultaneously manufacture a multitude of chemical sensors (as common in processes for manufacturing CMOS circuitry), with a first wafer being used for forming the respective substrate layers and a second wafer being used for forming the respective handling layers. Such simultaneous production of several chemical sensors according to the invention can lead to reduced manufacturing tolerances, also with respect to the vias.

### Brief Description of the Drawings

Further advantageous features and applications of the invention can be found in the dependent claims, as well as in the following description of the drawing illustrating the invention. The sole Figure shows a schematic sectional view of a chemical sensor according to the invention. It is noted that the drawing in the sole Figure is purely schematic and out of scale.

### Mode(s) for Carrying out the Invention

The sole Figure depicts a chemical sensor 1 according to the invention. The chemical sensor 1 comprises a substrate layer 2 with a front surface 2.1 and a back surface 2.2. The substrate layer 2 preferably consists of silicon. On top of the substrate layer 2 a sensing layer 3 is arranged, the sensing layer 3 made of a dielectric material such as silicon oxide or silicon nitride. The sensing layer 3 comprises a sensing element 4. The substrate layer 2 is provided with a well 5 in the back surface 2.2 to form a membrane 6 that incorporates the sensing element 4.

The sensing element 4 preferably comprises a fluid-sensitive, in particular a gas-sensitive, film 7 and a heater 8 made out of metal for heating the fluid-sensitive film 7 to promote a chemical reaction of the fluid to be analysed with the fluid-sensitive film 7. For this the fluid-sensitive film 7 is formed on the front surface 3.1 of the sensing layer 3 with the heater 8 located beneath the fluid-sensitive film 7 in the sensing layer 3. The sensing element 4 furthermore incorporates electrodes 9 to which the fluid-sensitive film 7 is connected, the electrical output of the electrodes 9 being indicative of the one or more properties of the fluid to be analysed. Of course, other types of sensing elements 4 with different architecture and composition may be employed.

A membrane 6 that incorporates a heater 8 is also called hotplate, with the corresponding chemical sensor 1 being also called hotplate chemical sensor. Often CMOS circuitry such as CMOS-based transistors is provided on the front surface 2.1 of the substrate layer 2 laterally from the hotplate. However, for proper functioning the CMOS circuitry must be kept cooler than the hotplate. To achieve this, the thickness of the substrate layer 2 is preferably (much) thinner than the lateral dimension/elongation of the membrane 6 to drain the heat provided by the hotplate from the front surface 2.1 of the substrate layer 2 to contact pads 10 provided on the back surface 2.2 of the substrate layer 2, the contact pads 10 being described below in detail.

The substrate layer 2 is provided on the back surface 2.2 with contact pads 10 that can be electrically connected with an electrical circuit board (not shown). For electrical connection of the electrodes 9 of the sensing element 4 with the contact pads 10 vias 11, in particular through-silicon vias, are provided, each via 11 comprising a contact lead 14 that is connected - preferably by means of further contact leads 15 in the sensing layer 3 - to the electrodes 9 of the sensing element 4. The contact lead 14 of a via 11 is preferably given by a contact layer on the inner wall of the respective via 11. Preferentially, the contact leads or contact layers 14, respectively, are insulated from the substrate layer 2 by an insulation layer 16 that may be made of silicon dioxide, the insulation layer 16 also covering the back surface 2.2 of the substrate layer 2.

On the front surface 3.1 of the sensing layer 3 there is a handling layer 17 provided that may be connected to the front surface 3.1 by means of an adhesive layer 18. The handling layer 17 is preferably made of wafer material (in particular silicon) such as the substrate layer 2. The handling layer 17 - and consequently also the adhesive layer 18 - surround the sensing element 4, thereby forming a cavity 19 above the sensing element 4. The cavity 19 acts as reaction chamber for a reaction occurring between a fluid to be analysed and the fluid-sensitive film 7. For the chemical sensor 1 being arranged e.g. in a portable electronic device such as a smart phone, the cavity 19 is in flow connection with an opening/a port in the housing of the portable electronic device, such that a fluid passing the opening/port in the housing reaches the cavity 19 and hence the sensing element 4. Preferably, the cavity 19 is located beneath the opening/port of the portable electronic device.

The handling layer 17 may be thinned/reduced in thickness such the thickness d3 of the entire chemical sensor 1 corresponds to a predetermined thickness. The thickness d1 of the handling layer 17 may be adjusted through grinding and polishing, respectively, such that the front surface 17.1 of the handling layer 17 is smooth/even, at least for a transverse surface area of 30 per cent, preferably 50 per cent, of the entire chemical sensor 1. The terms "smooth" and "even" mean that there are basically no vertical structures in the front surface 17.1 of the handling layer 17. As mentioned above, the handling layer 17 preferably consists of silicon or glass, i.e. it is gas-tight.

In particular due to its smooth front surface 17.1 the handling layer 17 may be used for sealing, in that the front surface 17.1 of the handling layer 17 is sealingly connected to the inner wall of the housing of a portable electronic device, the handling layer 17 surrounding a port/opening in the housing through which a fluid to be analysed can pass. Such sealing of the port/opening in the portable electronic device leads to fluid passing through the opening/port being able to reach the cavity 19 and the sensing element 4 but advantageously being prevented from reaching other interior areas of the portable electronic device.

Additionally, a sealing element in form of e.g. a spacer (not shown) can be provided on the front surface 17.1 of the handling layer 17, the spacer sealingly surrounding the opening/port. I.e. the spacer may have the shape of an O-ring. The spacer preferably consists of a material that is less hard than the material of the handling layer 17. Preferentially, the material of the sealing element is of some resilience.

The handling layer 17 serves for protecting the sensing element 4, especially the fluid-sensitive film 7, and for mechanical handling of the chemical sensor 1. The substrate layer 2 may be relieved of the handling function and the electrical connections provided by the vias 11 can be short. Hence, the thickness d1 of the handling layer 17 is larger than the thickness of the substrate layer 2. Preferably, the thickness of the handling layer 17 is at least 50 per cent of the thickness d3 of the entire chemical sensor 1. The thickness d3 of the chemical sensor 1 may, for example, lie in the range from 300 to 600 microns, with the thickness d1 of the handling layer 17 being in the range from 200 to 500 microns and the thickness d2 of the substrate layer 2 being in the range from 50 to 200 microns (depending on the thickness d1 of the handling layer 17).

It is to be understood that while certain embodiments of the present invention have been illustrated and described herein, the invention is not to be limited to the specific embodiments described and shown.

## Claims

1. A chemical sensor comprising a substrate layer (2) having a front surface (2.1) and a back surface (2.2) and a sensing layer (3) arranged on the front surface (2.1) of the substrate layer (2), the sensing layer (3) comprising a sensing element (4) and the substrate layer (2) being provided with a well (5) in the back surface (2.2) to a form a membrane (6) that incorporates the sensing element (4), **characterized in that**
- the substrate layer (2) is provided with contact pads (10) on the back surface (2.2) and with vias (11) extending from the front surface (2.1) to the back surface (2.2) for electrically connecting the sensing element (4) with the contact pads (10),
- wherein a handling layer (17) is provided on top of the sensing layer (3), the handling layer (17) surrounding the sensing element (4), and
- wherein the thickness (d1) of the handling layer (17) is larger than the thickness (d2) of the substrate layer (2).

2. The chemical sensor according to claim 1, wherein the thickness (d1) of the handling layer (17) is at least 50 per cent of the thickness (d3) of the entire chemical sensor (1).

3. The chemical sensor according to claim 1 or 2, wherein the thickness (d1) of the handling layer (17) is in the range from 200 to 500 microns.

4. The chemical sensor according to one of the preceding claims, wherein the thickness (d2) of the substrate layer (2) is less than the lateral elongation of the membrane (6).

5. The chemical sensor according to one of the preceding claims, wherein the thickness (d2) of the substrate layer (2) is in the range from 50 to 200 microns.

6. The chemical sensor according to one of the preceding claims, wherein the handling layer (17) is made of silicon or glass.

7. The chemical sensor according to one of the preceding claims, wherein the front surface (17.1) of the handling layer (17) is smooth.

8. A method for manufacturing a chemical sensor according to one of the preceding claims, the method comprises the following steps:
- forming a sensing layer (3) that includes the sensing element (4) on a bulk substrate,
- forming a handling layer (17) on top of the sensing layer (3) that surrounds the sensing element (4),
- reducing the thickness of the bulk substrate to a thickness (d2) that is lesser than the thickness (d1) of the handling layer (17), thereby forming the substrate layer (2) from the bulk substrate,
- forming vias (11) in the substrate layer (2), the vias (11) extending from the front surface (2.1) to the back surface (2.2) of the substrate layer (2), and
- forming a well (5) in the back surface (2.2) of the substrate layer (2) to leave a membrane (6) that incorporates the sensing element (4).

9. The method according to claim 8, wherein the thickness of the bulk substrate is reduced to a thickness (d2) such that the thickness (d1) of the handling layer (17) is less than 50 per cent of the thickness (d3) of the entire chemical sensor (1) to form the substrate layer (2).

10. The method according to claim 8 or 9,
wherein the thickness (d1) of the handling layer (17) is in the range from 200 to 500 microns.

11. The method according to one of the claims 8 to 10, wherein the thickness of the bulk substrate is reduced to a thickness (d2) that is in the range from 50 to 200 microns to form the substrate layer (2).

12. The method according to one of the claims 8 to 11, wherein the well (5) is formed such in the back surface (2.2) of the substrate layer (2) that the lateral elongation of the membrane (6) is larger than the thickness (d2) of the substrate layer (2).

13. The method according to one of the claims 8 to 12, wherein for forming the handling layer (17) on top of the sensing layer (3) an adhesive layer (18) is provided on top of the sensing layer (3), the adhesive layer (18) surrounding the sensing element (4) and connecting the handling layer (17) to the top of the sensing layer (3).

14. The method according to one of the claims 8 to 13, wherein the handling layer (17) is made of silicon or glass.

15. The method according to one of the claims 8 to 14, where the top of the handling layer (17) is grinded to form a smooth front surface (17.1) of the handling layer.
